# EUROPÄISCHE PATENTSCHRIFT

(11) **EP 2 506 309 B1**
(45) Veröffentlichungstag und Bekanntmachung des Hinweises auf die Patenterteilung: **27.09.2017**
(21) Anmeldenummer: 12154824.2
(22) Anmeldetag: 10.02.2012
(51) Int. Cl.: H01L 29/872, H01L 29/06, H01L 29/47

(54) **Schottky-Diode und Herstellungsverfahren hierzu**
Schottky diode and corresponding production method
Diode Schottky et son procédé de fabrication

(30) Priorität: 31.03.2011 DE 102011006492
(43) Veröffentlichungstag der Anmeldung: 03.10.2012
(73) Patentinhaber: SEMIKRON Elektronik GmbH & Co. KG, 90431 Nürnberg (DE)
(72) Erfinder: Starovecky, Stefan, 921 01 Piestany (SK); Krempaská, Olga, 921 01 Piestany (SK); Predmerský, Martin, 921 01 Piestany (SK)

(56) Entgegenhaltungen:
- DE-A1- 19 544 326
- JP-A- 2004 207 418
- US-A- 5 686 753
- US-A1- 2009 309 181
- US-B1- 7 791 136

## Beschreibung

Die Erfindung beschreibt eine volumenleitfähige Schottky-Diode sowie ein Verfahren zu deren Herstellung, vorzugsweise der Herstellung gleichartiger Dioden in einem Waferverbund. Grundsätzlich sind Schottky-Dioden seit langem, beispielhaft aus der EP 0 054 655 A2 oder der US 4,398,344 bekannt. Grundsätzlich vorteilhaft an Schottky-Dioden, speziell derjenigen die aus einem Verbindungshalbleitermaterial bestehen, gegenüber Halbleiterdioden mit pn-Übergang ist ihr besonders schnelles Schaltverhalten, also die Möglichkeit mit hoher Frequenz vom Vorwärts- in den Sperrbetrieb übergehen zu können. Aus diesem Grund eignen sich Schottky-Dioden auch bereits diejenigen auf Siliziumbasis besonders als Schutzdioden in verschiedensten Anwendungen.

Ein weiterer wesentlicher Vorteil der Schottky-Dioden liegt in dem im Vergleich geringeren Spannungsabfall in Flussrichtung. Dieser Vorteil ist beispielhaft beim Einsatz als Schutzdiode in Photovoltaikanlagen bedeutsam.

Aus der US 7,791,136 B1 sowie grundsätzlich auch aus der US 2009/0309181 A1 sind Schottky-Dioden bekannt, die eine Zellstruktur mit eine Mehrzahl von Zellen pro Diode und innerhalb dieser Zellen eine Mehrzahl von Gräben aufweisen. Derartige Schottky-Dioden können integraler Bestandteil einer komplexeren Halbleiterstruktur sein, wobei verschiedene Bereich verschieden Funktionalität aufweisen.

Der Erfindung liegt die Aufgabe zugrunde eine mechanisch robuste Schottky-Diode, wie auch ein zugehöriges Herstellungsverfahren, vorzustellen, die auch bei höhere Spannungen und Strömen schnelles schalten erlaubt.

Die Aufgabe wird erfindungsgemäß gelöst, durch eine Schottky-Diode mit den Merkmalen des Anspruchs 1 und durch ein Herstellungsverfahren mit den Merkmalen des Anspruchs 7. Bevorzugte Ausführungsformen sind in den jeweiligen abhängigen Ansprüchen beschrieben.

Ausgangspunkt der Erfindung ist eine Schottky-Diode mit einer ersten und einer zweiten Haupt- sowie einer Randfläche. Ausgehend von der ersten Hauptfläche betrachtet weist die erfindungsgemäße Schottky-Diode einen schichtweisen Aufbau auf, wobei alle Schichten eine unterschiedliche Dicke aufweisen können, allerdings alle parallel zueinander ausgerichtet sind.

Die erste sich an die erste Hauptfläche der Schottky-Diode anschließende Schicht ist ein Halbleitergrundkörper mit einer ersten hohen Dotierstoffkonzentration, die zu einer hohen Leitfähigkeit der Schicht führt. An diesen Grundkörper schließt sich auf seiner der ersten Hauptfläche abgewandten Seite eine Halbleiterschicht gleicher Leitfähigkeit wie diejenige des Grundkörpers an. Allerdings weist diese Halbleiterschicht eine um Größenordnungen geringerer Dotierstoffkonzentration auf.

Auf dieser Halbleiterschicht ist eine erste Metallschicht angeordnet, wobei an der Grenzfläche der beiden Schichten zueinander der Schottky-Kontakt ausgebildet ist. An diese erste Metallschicht schließt sich vorzugsweise eine zweite als Migrationsbarriere ausgebildete Metallschicht an. Diese beispielhaft aus Titan gebildete Metallschicht verhindert das Eindringen von Metallatomen durch diese Schicht hindurch in die erste Metallschicht hinein. Dort könnten derartige Metallatome die Funktion des Schottky-Kontakts behindern.

Auf der ersten oder falls vorhanden zweiten Metallschicht ist eine Schicht aus einem Verbindungsmittel angeordnet, das der Verbindung dieser Metallschicht mit einem flächigen Kontaktkörper dient. Dieser Kontaktkörper kann hierbei aus einem Metall oder einem hochdotierten Halbleitermaterial bestehen. Das zugeordnete Verbindungsmittel ist vorzugsweise als eine ein- oder mehrlagige weitere Metallschicht oder als eine leitfähige Klebeverbindung ausgebildet. Die dem Verbindungsmittel abgewandte Hauptfläche des Kontaktkörpers bildet die zweite Hauptfläche der Schottky-Diode aus.

Die Randfläche der Schottky-Diode kann senkrecht zu den Schichten, speziell der mindestens einen Metallschicht ausgerichtet sein. Es kann aber besonders bei Schottky-Dioden für hohe Spannungen zumindest in demjenigen Bereich der Randfläche an der der Schottky-Kontakts auf diese stößt bevorzugt sein, wenn hier die Randfläche mit den Schichten einen Winkel einschließt, der um mehr als 5 Grad von einem rechten Winkel abweicht.

Weiterhin ist eine, diese Randfläche der Schottky-Diode vollständig oder teilweise bedeckende Passivierungsschicht vorgesehen. Bei nur teilweiser Bedeckung ist hierbei zumindest derjenige Abschnitt des Randbereichs um den Schottky-Kontakt, also sowohl unter- wie oberhalb dessen, überdeckt. Bei vollständiger Bedeckung reicht die Passivierungsschicht von der ersten zur zweiten Hauptfläche.

Gemäß der erfinderischen Ausgestaltung bilden die Hauptflächen der Schottky-Diode gleichzeitig die jeweils erste und zweite elektrische Kontaktfläche aus. Hierbei kann es bevorzugt sein, wenn auf mindestens eine dieser Kontaktflächen eine weitere metallische Kontaktschicht vorgesehen ist. Insbesondere, wenn der Kontaktkörper nicht metallisch ausgebildet ist, kann es erforderlich sein um die Schottky-Diode extern verbinden zu können dort eine weitere metallische Kontaktschicht vorzusehen, die auch als Mehrschichtkontakt ausgebildet sein kann.

Das erfindungsgemäße Verfahren zur Herstellung mindestens einer derartigen volumenleitfähigen Schottky-Diode ist gekennzeichnet durch die folgenden Verfahrensschritte:

Bereitstellen eines Halbleitergrundkörpers mit hoher Dotierstoffkonzentration, damit die Leitungsverluste beim Stromdurchgang möglichst minimal sind. Eine erste Hauptfläche dieses Halbleitergrundkörpers bildet auch die erste elektrische Kontaktfläche der späteren Schottky-Diode aus. Es ist selbstverständlich bevorzugt und aus dem Stand der Technik allgemein bekannt, wenn im Rahmen des Verfahrens eine Mehrzahl von Schottky-Dioden hergestellt werden. Hierzu liegt der Halbleitergrundkörper in Form eines Wafers vor, aus dem in einem späteren Verfahrensschritt die einzelnen Schottky-Dioden vereinzelt werden.

Auf der der ersten Hauptfläche gegenüberliegenden Fläche des Halbleitergrundkörpers wird anschließend eine Halbleiterschicht gleicher Leitfähigkeit wie der Halbleitergrundkörper aber geringerer Dotierstoffkonzentration, die notwendig ist für die Ausbildung eines Schottky-Kontakts, eptiaktisch abgeschieden.

Anordnen einer ersten Metallschicht auf der Halbleiterschicht, wodurch der Schottky-Kontakt zwischen dieser ersten Metallschicht und der Halbleiterschicht ausgebildet wird.

Vorzugsweises Anordnen einer zweiten Metallschicht als Migrationsbarriere auf der ersten Metallschicht. Für beide Metallschichten kann es bevorzugt diese in einem Aufdampf-, einem Sputter-, oder einem Abscheideverfahren aus der Flüssigphase aufzubringen, wobei sich die Verfahren für beide Metallschicht durchaus unterscheiden können.

In einem weiteren Schritt wird ein flächiger Kontaktkörpers mit der ersten oder falls vorhanden zweiten Metallschicht mittels eines Verbindungsmittels verbunden. Auch für diese Verbindung können verschieden bekannte Verfahren, wie Klebe-, Löt- oder Sinterverfahren vorteilhaft sein.

Nach diesen bisher in vorteilhafter Weise auf den gesamten Wafer angewandte Verfahrensschritten werden in einem nächsten Schritt einzelne Schottky-Dioden ausgebildet. Hierzu ist es vorteilhaft den Wafer auf einer Trägereinrichtung, besonders bevorzugt als dehnbare Folie ausgebildet, anzuordnen.

Das Ausbilden mindestens einer Schottky-Diode, vorzugsweise das Vereinzeln einer Mehrzahl von Schottky-Dioden aus dem Waferverbund erfolgt mittels eines Sägeverfahrens, wodurch auch die horizontale Ausdehnung und damit die Stromtragfähigkeit der jeweiligen Schottky-Diode festgelegt wird. Es kann bevorzugt sein das Sägeverfahren als ein- oder zweistufiges Verfahren auszubilden, wobei jeweils im Anschluss bei der Vereinzelung aus dem Waferverbund die einzelnen Schottky-Dioden weiterhin im losen Verbund, gebildet durch die Trägereinrichtung vorliegen können.

Besonders bei einem zweistufigen Sägeverfahren ist es einfach möglich zumindest im Bereich des Schottky-Kontakts die Randfläche derart auszubilden, damit sie dort mit den Schichten, insbesondere der mindestens einen Metallschicht einen Winkel einschließt, der um mehr als 5 Grad von einem rechten Winkel abweicht.

Im Anschluss an das Sägeverfahren ist es weiterhin vorteilhaft den Randbereich zumindest im Bereich des Schottky-Kontakts einem Ätzverfahren zu unterziehen, damit mögliche defekte Volumenbereiche, die durch das Sägeverfahren entstanden sind, entfernt werden.

In einem weiteren Verfahrensschritt wird entweder auf der gesamten Randfläche oder zumindest auf demjenigen Abschnitt um den Schottky-Kontakt eine Passivierungsschicht angeordnet. Im Anschluss daran wird ggf. der lose Verbund der einzelnen Schottky-Dioden aufgelöst und die Schottky-Dioden vollständig vereinzelt.

Die erfinderische Lösung wird an Hand der Ausführungsbeispiele gemäß den Fig. 1 bis 8 weiter erläutert.
Fig. 1 bis 7 zeigt wesentliche Schritte eines erfindungsgemäßen Herstellungsverfahrens.
Fig. 8 zeigt eine erfindungsgemäße Schottky-Diode.

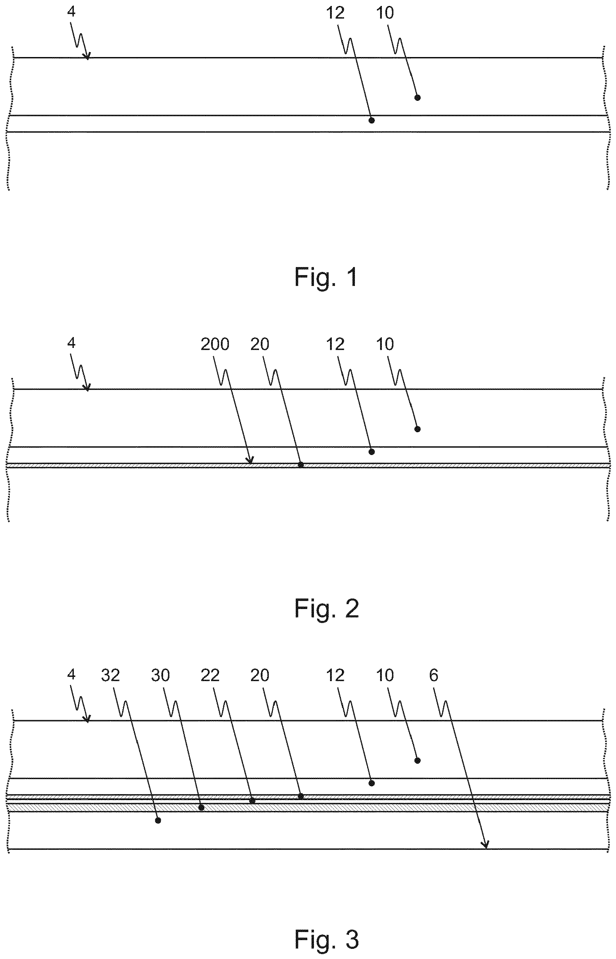

Fig. 1 zeigt einen Ausschnitt aus einem Wafer, der den Halbleitergrundkörper einer Mehrzahl von Schottky-Dioden ausbildet. Dieser Halbleitergrundkörper, vorzugsweise aus monokristallinem Silizium, weist ein hohe Konzentration von Dotierstoffen auf, so dass er einen spezifischen Widerstand von weniger als einem Milliohm pro Zentimeter, und damit eine hohe Leitfähigkeit, aufweist. Bevorzugt weist der Grundkörper eine n-Dotierung mit zugehöriger Leiterfähigkeit auf. Eine bevorzugte Dicke dieses Halbleitergrundkörpers liegt zwischen 80µm und 150µm, wobei auch dickere Halbleitergrundkörper beispielhaft mit einer Dicke zwischen 200µm und 300µm grundsätzlich ebenso geeignet sind. Eine erste Hauptfläche dieses Halbleitergrundkörpers bildet hierbei nach der Vereinzelung die jeweilige erste Kontaktfläche der jeweiligen Schottky-Diode aus.

Auf diesem Grundkörper ist eine epitaktisch abgeschiedene Halbleiterschicht gleicher Leitfähigkeit wie diejenige des Halbleitergrundkörpers aber geringer Dotierstoffkonzentration dargestellt. Diese Halbleiterschicht weist eine Dicke von wenigen Mikrometern und einen spezifischen Widerstand in der Größenordnung von einem Ohm pro Zentimeter auf.

Fig. 2 zeigt eine auf der Halbleiterschicht angeordnete erste Metallschicht, die an der Grenze zur Halbleiterschicht den Schottky-Kontakt und damit die grundsätzliche Funktionalität der Schottky-Diode ausbildet. Diese erste Metallschicht wird durch bekannte Verfahren insbesondere durch ein Sputterverfahren abgeschieden und bevorzugt im Anschluss getempert.

Fig. 3 zeigt in dieser Reihenfolge von der ersten Metallschicht an angeordnet eine zweite Metallschicht, ein Verbindungsmittel und einen flächigen Kontaktkörper. Dieser Kontaktkörper bildet nach der Vereinzelung mit seiner dem Verbindungsmittel abgewandten Hauptfläche die zweite Kontaktfläche der jeweiligen Schottky-Diode aus. Der flächige Kontaktkörper besteht bevorzugt aus Metall oder aus einem hochdotierten Halbleitermaterial, beispielhaft dem gleichen aus dem auch der Halbleitergrundkörper besteht. Die primäre Aufgabe dieses Kontaktkörpers besteht in der elektrischen Verbindung externer Anschlüsse mit der ersten Metallschicht also letztendlich mit dem Schottky-Kontakt. Hierzu weist dieser Kontaktkörper auch eine bevorzugte Dicke zwischen 100µm und 200µm auf.

Das Verbindungsmittel dient der elektrisch leitenden und mechanisch stabilen Befestigung des flächigen Kontaktkörpers. Hierzu wird weist das Verbindungsmittel an die Ausgestaltung des Kontaktkörpers angepasste Eigenschaften auf. Bespielhaft bei einem aus Molybdän bestehenden Kontaktkörper kann es bevorzugt sein, wenn das Verbindungsmittel als eine Lotschicht ausgebildet ist. Falls die Anforderungen an die Verbindung höher liegen, kann es sich auch um eine Sintermetallschicht handeln, die dann mit weiteren Edelmetallschichten beispielhaft auf dem Kontaktkörper kombiniert ist, wodurch sich eine mehrschichtige Ausgestaltung des Verbindungsmittels ergibt.

Bei einer Ausgestaltung des flächigen Kontaktkörpers aus einem Halbleitermaterial, kann es bevorzugt sein das Verbindungsmittel als eine Klebeverbindung auszugestalten.

Grundsätzlich ist weiterhin zwischen der ersten Metallschicht und dem Verbindungsmittel eine zweite Metallschicht vorgesehen, die als Migrationsbarriere wirkt und ein Eindringen von Atomen insbesondere Metallatomen, beispielhaft aus dem Verbindungsmittel oder dem flächigen Kontaktkörper in die erste Metallschicht hinein verhindert. Besonders geeignet ist hierfür Titan als Werkstoff der zweiten Metallschicht.

Es kann auch bevorzugt sein in einem nächsten nicht dargestellten Schritt auf der ersten und / oder zweiten Hauptfläche weitere metallische Kontaktschichten vorzusehen. Eine derartige Kontaktschicht auf der ersten Hauptfläche dient beispielhaft der elektrisch leitfähigen Löt- oder Sinterverbindung zu einem Substrat oder einem anderen Träger der Schottky-Diode. Eine Kontaktschicht auf der zweiten Hauptfläche dient ebenso der geeigneten elektrisch leitfähigen Verbindung zu einem externen Anschlusselement.

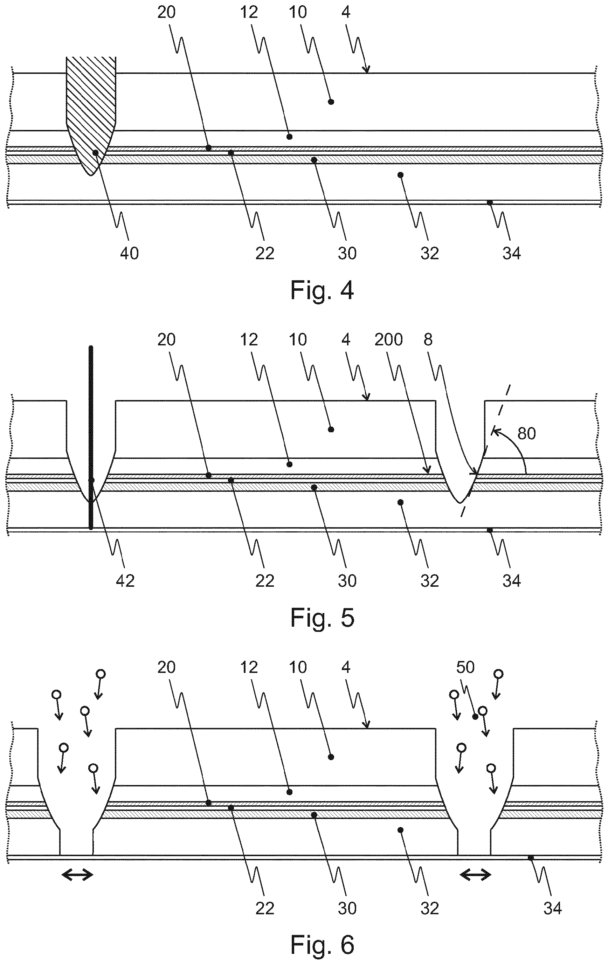

Fig. 4 erläutert einen ersten Sägeschnitt der die Schottky-Dioden teilweise aber noch nicht vollständig vereinzelt. Es ist hier bereits eine Trägereinrichtung, beispielsweise eine im Waferhandling bekannte Trägerfolie an der zweiten Hauptfläche also der freien Oberfläche des flächigen Kontaktkörpers angeordnet. Diese Trägerfolie dient hauptsächlich dazu, dass nach vollständigem Abschluss des Sägeverfahrens die dann vorliegenden Schottky-Dioden noch in einem losen Verbund angeordnet bleiben und weiteren Prozessschritten gemeinsam zugänglich sind.

Durch diesen ersten Sägeschritt entsteht bereits teilweise eine Randfläche der Schottky-Diode. Mit der dargestellten Sägevorrichtung mit einem V-förmigen Sägeblatt wird in dem Abschnitt der Randfläche um den Schottky-Kontakt ein Winkel, vgl. Fig. 5, zu den Metallschichten ausgebildet wird, der von einem rechten Winkel um mehr als 5 Grad, vorzugsweise im Bereich von 10 Grad, abweicht. Hierzu reicht der erste Sägeschnitt vom Halbleitergrundkörper aus bis in den flächigen Kontaktkörper hinein.

Fig. 5 zeigt einen zweiten Sägeschnitt, mittels dem die Schottky-Dioden vollständig vereinzelt werden, allerdings noch in dem losen Verbund mittels der Trägerfolie verbleiben. Dieser zweite Sägeschnitt erfolgt mittig in der durch den ersten Sägeschnitt entstandenen Ausnehmung mittels einer im Vergleich zum ersten Sägeschnitt dünner ausgebildeten Sägevorrichtung. Somit bleibt in einem Abschnitt der Randfläche um den Schottky-Kontakt herum ein oben beschriebener Winkel der Randfläche erhalten. Auch zur Ausbildung dieses Winkels mittels des genannten Sägeverfahrens ist das Vorsehen des Kontaktkörpers wesentlich. Der Vorteil diese Ausgestaltung der Randfläche liegt in der höheren Durchbruchfestigkeit der somit entstehenden Schottky-Diode.

Fig. 6 zeigt vereinzelte Schottky-Dioden im losen Verbund mittels der Trägerfolie, wobei hier der Abstand der Schottky-Dioden zueinander dadurch vergrößert wurde, dass die Folie in zwei orthogonale Richtungen, eindimensional angedeutet durch den Doppelpfeil, gedehnt wurde.

Ebenfalls dargestellt ist ein vorteilhafter Verfahrensschritt, bei dem die durch das Sägen ausgebildeten Randflächen der Schottky-Dioden in einem Ätzverfahren behandelt werden. Es ist hierbei bevorzugt ein reaktives lonenätzverfahren einzusetzen. Ebenso ist es möglich nasschemisch zu ätzen. Bei beiden Verfahren kann es zudem vorteilhaft sein die erste Hauptfläche abzudecken und somit vor dem Ätzmedium zu schützen.

Durch das Ätzverfahren bei dem einige Mikrometer der Randfläche abgetragen werden, werden die dort durch das Sägen verursachten defekten Volumenbereiche entfernt.

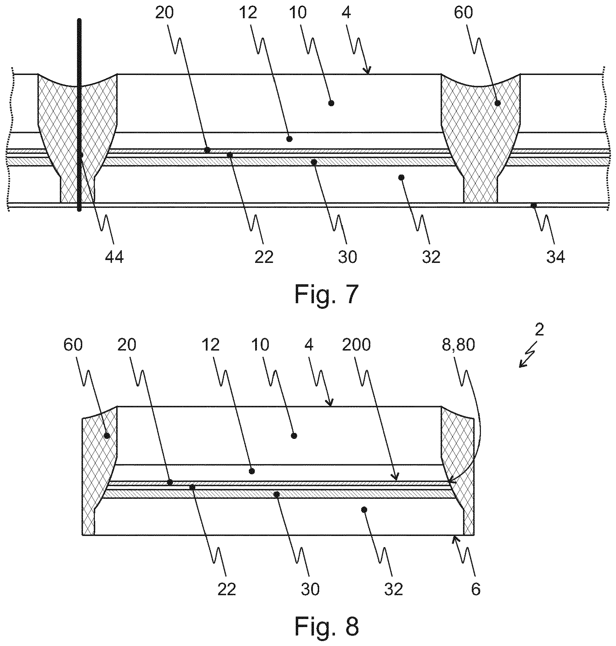

Fig. 7 zeigt die durch das Sägen entstandenen Ausnehmungen des Wafers mit einem passivierenden, organischen Isolationsmaterial verfüllt. Dieses Isolationsmaterial reicht hier von der ersten zur zweiten Hauptfläche und bedeckt somit die gesamte Randfläche der Schottky-Dioden.

Ebenfalls dargestellt ist eine abschließende vollständige Vereinzelung der Schottky-Dioden aus dem losen Verbund heraus durch eine Trennung mittig durch das Isolationsmaterial.

Fig. 8 zeigt eine einzelne erfindungsgemäße Schottky-Diode mit einem schichtweisen Aufbau aus den parallel angeordneten Schichten: Halbleitergrundkörper, Halbleiterschicht, erste Metallschicht, zweite bevorzugte Metallschicht, Verbindungsmittel und flächigem Kontaktkörper. Der Schottky-Kontakt ist hierbei zwischen der Halbleiterschicht und der ersten Metallschicht ausgebildet.

Dieser Schichtaufbau weist eine Randfläche auf, die mit einer aus einem organischen Isolationsmaterial bestehenden Passivierungsschicht vollständig umschlossen ist.

## Patentansprüche

1. Schottky-Diode (2) mit einer ersten (4) und einer zweiten (6) Haupt- sowie einer Randfläche (8), wobei die jeweilige Hauptfläche (4, 6) gleichzeitig die jeweils erste und zweite elektrische Kontaktfläche ausbilden,
mit einem schichtweisen Aufbau aus einem Halbleitergrundkörper (10) mit einer ersten hohen Dotierstoffkonzentration, einer Halbleiterschicht (12) gleicher Leitfähigkeit und geringerer Dotierstoffkonzentration, einer den Schottky-Kontakt (200) mit dieser Halbleiterschicht ausbildende erste Metallschicht (20), einer Schicht aus einem Verbindungsmittel (30) und einer hierüber mit einer zweiten Metallschicht (22) verbundenen flächigen Kontaktkörper (32) und
mit einer Passivierungsschicht (60) der Randfläche (8) der Schottky-Diode (2), die zumindest denjenigen Abschnitt der Randfläche (8) um den Schottky-Kontakt (200) überdeckt, wobei die Randfläche (8) zumindest im Bereich des Schottky-Kontakts (200) mit den Schichten einen Winkel (80) einschließt, der um mehr als 5 Grad von einem rechten Winkel abweicht.

2. Schottky-Diode nach Anspruch 1, wobei
zwischen der ersten Metallschicht (20) und der Schicht aus einem Verbindungsmittel (30) noch eine zweite eine Migrationsbarriere ausbildende Metallschicht (22) vorgesehen ist.

3. Schottky-Diode nach Anspruch 1, wobei
der flächige Kontaktkörper (32) aus einem Metall oder einem hochdotierten Halbleitermaterial besteht.

4. Schottky-Diode nach Anspruch 1, wobei
das Verbindungsmittel (30) eine ein- oder mehrlagig weitere Metallschicht oder eine leitfähige Klebeverbindung ist.

5. Schottky-Diode nach Anspruch 1, wobei
auf der ersten und / oder zweiten Hauptfläche (4, 6) weitere metallische Kontaktschichten vorgesehen sind.

6. Schottky-Diode nach Anspruch 1, wobei
die Passivierungsschicht (60) die Randfläche (8) vollständig, von der ersten (4) zur zweiten (6) Hauptfläche reichend bedeckt.

7. Verfahren zur Herstellung mindestens einer Schottky-Diode (2) nach einem der vorhergehenden Ansprüche, **gekennzeichnet durch** die folgenden Verfahrensschritte:
• Bereitstellen eines Halbleitergrundkörpers (10), vorzugsweise in Form eines Wafers, hoher Dotierstoffkonzentration mit einer ersten Hauptfläche (4), die die erste elektrische Kontaktfläche ausbildet;
• Eptiaktisches Abscheiden einer Halbleiterschicht (12) gleicher Leitfähigkeit und geringerer Dotierstoffkonzentration auf der der ersten Hauptfläche (4) gegenüberliegenden Fläche des Halbleitergrundkörpers (10);
• Anordnen einer ersten Metallschicht (20) auf der Halbleiterschicht (12) unter Ausbilden eines Schottky-Kontakts (200) zwischen der ersten Metallschicht (20) und der Halbleiterschicht (12);
• Verbinden eines flächigen Kontaktkörpers (32) mit der ersten Metallschicht (20) mittels eines Verbindungsmittels (30);
• Ausbilden mindestens einer einzelnen Schottky-Diode (2), wobei der zumindest im Bereich des Schottky-Kontakts (200) die Randfläche (8) mit den Schichten, insbesondere den Metallschichten (20, 22) einen Winkel (80) einschließt, der um mehr als 5 Grad von einem rechten Winkel abweicht;
• Anordnen einer Passivierungsschicht (60) im Randbereich (8) der mindestens einen Schottky-Diode (2).

8. Verfahren nach Anspruch 7, wobei
die erste Metallschicht (20) und / oder eine zweite zwischen dieser ersten Metallschicht (20) und dem Verbindungsmittel (30) angeordneten Metallschicht (22) in einem Aufdampf-, einem Sputter-, oder einem Abscheideverfahren aus der Flüssigphase aufgebracht werden.

9. Verfahren nach Anspruch 7 oder 8, wobei
die Verbindung des flächigen Kontaktkörpers (32) mit der ersten (20) oder der zweiten Metallschicht (22) mittels eines Klebe-, Löt- oder Sinterverfahrens erfolgt.

10. Verfahren nach Anspruch 7, wobei
das Ausbilden der mindestens einen Schottky-Diode (2) mittels eines ein- oder zweistufigen Sägeverfahrens (40, 42) erfolgt.

11. Verfahren nach Anspruch 10, wobei
im Anschluss an das Sägeverfahren (40, 42) der Randbereich (8) zumindest im Bereich des Schottky-Kontakts (200) der mindestens einen Schottky-Diode (2) einem Ätzverfahren (50) unterzogen wird.

12. Verfahren nach einem der Ansprüche 7 bis 11, wobei
beim Ausbilden einer Mehrzahl von Schottky-Diode (2) der Wafer auf einer Trägereinrichtung (34) angeordnet ist und somit ein loser Verbund einzelner Schottky-Dioden (2) besteht.

13. Verfahren nach Anspruch 12, wobei
nach Anordnen der Passivierungsschicht (60) die Schottky-Dioden (2) vollständig vereinzelt werden.

## Claims

1. Schottky diode (2) having a first (4) and a second (6) main surface and an edge surface (8), wherein the respective main surface (4, 6) simultaneously forms the respective first and second electrical contact surface,
comprising a layered construction composed of a semiconductor base body (10) having a first, high dopant concentration, a semiconductor layer (12) having the same conductivity and a lower dopant concentration, a first metal layer (20) forming the Schottky contact (200) with said semiconductor layer, a layer composed of a connecting means (30) and a planar contact body (32) connected to a second metal layer (22) via said layer composed of a connecting means, and
comprising a passivation layer (60) of the edge surface (8) of the Schottky diode (2) which covers at least that portion of the edge surface (8) around the Schottky contact (200), wherein
the edge surface (8) at least in the region of the Schottky contact (200) forms an angle (80) with the layers which deviates from a right angle by more than 5 degrees.

2. Schottky diode according to Claim 1, wherein
a second metal layer (22) forming a migration barrier is also provided between the first metal layer (20) and the layer composed of a connecting means (30).

3. Schottky diode according to Claim 1, wherein
the planar contact body (32) consists of a metal or a highly doped semiconductor material.

4. Schottky diode according to Claim 1, wherein
the connecting means (30) is a mono- or multilayered further metal layer or a conductive adhesive connection.

5. Schottky diode according to Claim 1, wherein
further metallic contact layers are provided on the first and/or second main surface (4, 6).

6. Schottky diode according to Claim 1, wherein
the passivation layer (60) covers the edge surface (8) completely, extending from the first (4) to the second (6) main surface.

7. Method for producing at least one Schottky diode (2) according to any of the preceding claims, **characterized by** the following method steps:
• providing a semiconductor base body (10), preferably in the form of a wafer, having a high dopant concentration and having a first main surface (4), which forms the first electrical contact surface;
• epitaxially depositing a semiconductor layer (12) having the same conductivity and a lower dopant concentration on that surface of the semiconductor base body (10) which lies opposite the first main surface (4);
• arranging a first metal layer (20) on the semiconductor layer (12) with the formation of a Schottky contact (200) between the first metal layer (20) and the semiconductor layer (12) ;
• connecting a planar contact body (32) to the first metal layer (20) by means of a connecting means (30);
• forming at least one individual Schottky diode (2), wherein
at least in the region of the Schottky contact (200), the edge surface (8) forms an angle (80) with the layers, in particular the metal layers (20, 22), which deviates from a right angle by more than 5 degrees;
• arranging a passivation layer (60) in the edge region (8) of the at least one Schottky diode (2) .

8. Method according to Claim 7, wherein
the first metal layer (20) and/or a second metal layer (22) arranged between said first metal layer (20) and the connecting means (30) are/is applied in a vapour deposition method, a sputtering method or a deposition method from the liquid phase.

9. Method according to Claim 7 or 8, wherein
the planar contact body (32) is connected to the first (20) or the second metal layer (22) by means of an adhesive-bonding, soldering or sintering method.

10. Method according to Claim 7, wherein
the at least one Schottky diode (2) is formed by means of a one- or two-stage sawing method (40, 42) .

11. Method according to Claim 10, wherein
after the sawing method (40, 42), the edge region (8) at least in the region of the Schottky contact (200) of the at least one Schottky diode (2) is subjected to an etching method (50).

12. Method according to any of Claims 7 to 11, wherein when forming a plurality of Schottky diodes (2), the wafer is arranged on a carrier device (34) and a loose assemblage of individual Schottky diodes (2) thus exists.

13. Method according to Claim 12, wherein
after the passivation layer (60) has been arranged, the Schottky diodes (2) are completely singulated.

## Revendications

1. Diode Schottky (2) avec une première (4) et une deuxième (6) surface principale ainsi qu'une surface de bord (8), dans laquelle les surfaces principales (4, 6) respectives forment simultanément respectivement la première et la deuxième surface de contact électrique,
avec une structure en couches en un corps de base semi-conducteur (10) avec une première concentration élevée en dopants, une couche semi-conductrice (12) de même conductivité et à plus faible concentration en dopants, une première couche métallique (20) formant le contact de Schottky (200) avec cette couche semi-conductrice, une couche en un agent de liaison (30) et un corps de contact plan (32) relié par l'intermédiaire de celle-ci à une deuxième couche métallique (22) et
avec une couche de passivation (60) de la surface de bord (8) de la diode Schottky (2), laquelle recouvre au moins cette partie de la surface de bord (8) autour du contact de Schottky (200), dans laquelle, au moins dans la zone du contact de Schottky (200), la surface de bord (8) forme un angle (80) avec les couches, lequel diffère de plus de 5 degrés d'un angle droit.

2. Diode Schottky selon la revendication 1, dans laquelle
on prévoit, entre la première couche métallique (20) et la couche en un agent de liaison (30), encore une deuxième couche métallique (22) formant une barrière anti-migration.

3. Diode Schottky selon la revendication 1, dans laquelle
le corps de contact plan (32) se compose d'un métal ou d'un matériau semi-conducteur fortement dopé.

4. Diode Schottky selon la revendication 1, dans laquelle
l'agent de liaison (30) est une autre couche métallique mono ou multicouche, ou une liaison adhésive conductrice.

5. Diode Schottky selon la revendication 1, dans laquelle
on prévoit, sur la première et/ou la deuxième surface principale (4, 6), d'autres couches de contact métalliques.

6. Diode Schottky selon la revendication 1, dans laquelle
la couche de passivation (60) recouvre complètement la surface de bord (8), en allant de la première (4) à la deuxième (6) surface principale.

7. Procédé pour la fabrication d'au moins une diode Schottky (2) selon l'une des revendications précédentes, **caractérisé par** les étapes suivantes du procédé :
- la mise à disposition d'un corps de base semi-conducteur (10), de préférence sous la forme d'une tranche, à concentration élevée en dopants avec une première surface principale (4), laquelle forme la première surface de contact électrique ;
- le dépôt par épitaxie d'une couche semi-conductrice (12) de même conductivité et à plus faible concentration en dopants sur la surface située en vis-à-vis de la première surface principale (4) du corps de base semi-conducteur (10) ;
- la mise en place d'une première couche métallique (20) sur la couche semi-conductrice (12) en formant un contact de Schottky (200) entre la première couche métallique (20) et la couche semi-conductrice (12) ;
- la mise en liaison d'un corps de contact plan (32) avec la première couche métallique (20) au moyen d'un agent de liaison (30) ;
- la formation d'au moins une diode Schottky (2) individuelle, le au moins dans la zone du contact de Schottky (200), la surface de bord (8) formant avec les couches, en particulier les couches métalliques (20, 22), un angle (80) qui diffère de plus de 5 degrés d'un angle droit ;
- la mise en place d'une couche de passivation (60) dans la zone de bord (8) de l'au moins une diode Schottky (2).

8. Procédé selon la revendication 7, dans lequel
la première couche métallique (20) et/ou une deuxième couche métallique (22) disposée entre cette première couche métallique (20) et l'agent de liaison (30) sont appliquées par un procédé de métallisation sous vide, de pulvérisation cathodique ou de dépôt à partir de la phase liquide.

9. Procédé selon la revendication 7 ou 8, dans lequel
la mise en liaison du corps de contact plan (32) avec la première (20) ou la deuxième couche métallique (22) s'effectue au moyen d'un procédé de collage, de soudage ou de frittage.

10. Procédé selon la revendication 7, dans lequel
la formation de l'au moins une diode Schottky (2) s'effectue au moyen d'un procédé de sciage à une ou deux étapes (40, 42).

11. Procédé selon la revendication 10, dans lequel,
à la suite du procédé de sciage (40, 42), au moins dans la zone du contact de Schottky (200) de l'au moins une diode Schottky (2), la zone de bord (8) est soumise à un procédé de gravure (50).

12. Procédé selon l'une des revendications 7 à 11, dans lequel,
lors de la formation d'une pluralité de diodes Schottky (2), la tranche est disposée sur un dispositif de support (34) et une liaison détachable de diodes Schottky (2) individuelles étant ainsi donnée.

13. Procédé selon la revendication 12, dans lequel,
après la mise en place de la couche de passivation (60), les diodes Schottky (2) sont complètement séparées.
